# EUROPEAN PATENT APPLICATION

(11) **EP 4 383 658 A1**
(43) Date of publication of application: **12.06.2024**
(21) Application number: 23209900.2
(22) Date of filing: 14.11.2023
(51) Int. Cl.: H04L 25/02

(54) **MISMATCH REDUCTION OF CAPACITIVE CHANNELS IN A COMMUNICATION SYSTEM**

(30) Priority: 28.11.2022 US 202217994805
(71) Applicant: Infineon Technologies Austria AG, 9500 Villach (AT)
(72) Inventor: ESTESVES TAVORA, Felipe, 9500 Villach (AT); FERIANZ, Thomas, 9551 Bodensdorf (AT); DELLA FORTUNA, Salvatore Angelo, 9500 Villach (AT)
(74) Representative: Westphal, Mussgnug & Partner, Patentanwälte mbB

(57) **Abstract**

A first link disposed in a first capacitive channel (path) and a second link disposed in a second capacitive channel (path) of a communication system support conveyance of a respective differential signal from the first communication circuit to the second communication circuit of the communication system during a non-test mode. A controller controls the communication system to temporarily operate in a test mode to facilitate communications in the non-test mode. For example, while in the test mode, the controller determines adjustment settings in which to apply to an impedance adjustment circuit of the communication system to provide better RLC matching of the first capacitive channel and the second capacitive channel. Subsequent to the test mode and calibration, application of the adjustments to the first capacitive channel and the second capacitive channel reduce effects of a parasitic capacitance mismatch associated with at least the first link and the second link.

## Description

One of the main challenges in digital isolator architectures is the capability to withstand fast common mode surges across the galvanic barrier, a figure of merit known as Common Mode Transient Immunity (CMTI). Capacitive coupled digital isolators offer a better area usage while presenting a worse CMTI performance when compared to their inductively coupled counterpart. For this reason, improving the CMTI in capacitive coupled architectures is desirable.

The key element of the CMT surge that impacts the proper functionality of a differential communication system is the conversion of the common-mode signal into a differential-mode signal due to unbalanced (unmatched) elements in the communication channel. These mismatches can be present on a transmitter, receiver, and/or in the isolation channel that separates the transmitter and receiver.

This disclosure includes the observation that when the source of mismatch is present on the transmitter or receiver side, trimming procedures can be implemented on both dies to eliminate the source of unbalance. Or the mismatch present there can be guaranteed by design to be small enough to be neglected. However, the isolation channel entangles elements that are controlled by the back-end of a respective communication chip.

In contrast to conventional techniques, this disclosure includes novel ways of improving communications between communication nodes coupled via links. For example, the disclosure herein includes a new trimming methodology to reduce the mismatch of two different branches of a differential capacitive channel such that signal propagation delay over a first capacitive branch of the differential capacitive channel is substantially equal to signal propagation delay over a second capacitive branch of the differential capacitive channel. In other words, at least one aspect of the techniques as described herein include reducing a difference in the signal propagation delay in one capacitive channel to the other capacitive channel. The strategy is attained through the configuration of the TX/RX circuits into a design for test (DFT) mode which allows the measurement of the channel mismatch and subsequent adjustment.

More specifically, the disclosure herein includes an apparatus including a first communication circuit and a second communication circuit. A first link (such as disposed in a first capacitive channel) and a second link (such as disposed in a second capacitive channel) support conveyance of a respective differential signal from the first communication circuit to the second communication circuit of the communication system during a non-test mode. A controller controls the communication system to temporarily operate in a test mode to facilitate subsequent communications in the non-test mode. While in the test mode, the controller applies different adjustments to an impedance adjustment circuit of the communication system. The impedance adjustment circuit is coupled to the first link and the second link. The controller determines adjustment setting to apply to the communication system during the non-test mode to reduce effects of a parasitic capacitance mismatch between the first link and the second link.

As further discussed herein, the adjustments include adjustment of a capacitance of a capacitor in the adjustment circuit, the capacitor coupled to the first link.

Yet, in further examples, the adjustments include adjustment of a resistance a resistor in the adjustment circuit, the resistor coupled to the first link.

In one example, the second communication circuit (such as including a receiver circuit of the communication system) is operative to generate an output signal. The output signal is generated in the test mode and is generated based on a common signal inputted to both the first link and the second link during the test mode. The controller determines the adjustments to apply to the impedance adjustment circuit (such as RLC adjustments) based on states of the output signal during the test mode.

In still further examples, the communication system includes a first capacitive channel between the first communication circuit and the second communication circuit. The first capacitive channel includes the first link, bridging the first communication circuit to the second communication circuit. The first capacitive channel is a first communication path from the first communication circuit to the second communication circuit. The second capacitive channel includes the second link, bridging the first communication circuit to the second communication circuit. The second capacitive channel is a second communication path from the first communication circuit to the second communication circuit. As previously discussed, the combination of the first communication path (first capacitive channel) and the second communication path (second capacitive channel) support conveyance of a differential communication signal during non-test mode conditions. The adjustments determined during the test mode may include implementing adjustments to reduce effects associated with a capacitance of a first capacitor in the adjustment circuit. The first capacitor is coupled to the first capacitive channel. The adjustments determined during the test mode may further include implementing adjustments to reduce effects associated a capacitance of a second capacitor in the adjustment circuit. The second capacitor is coupled to the second capacitive channel. Via the one or more adjustments associated with the adjustment circuit, the controller provides matching of the first capacitive channel to the second capacitive channel.

In further examples, the first link may be a first wire bond connecting a first node of the first communication circuit to a first node of the second communication circuit; the second link may be a second wire bond connecting a second node of the first communication circuit to a second node of the second communication circuit. The first link may be fabricated to have different dimensions than the second link. In such an instance, the capacitance of the first link is different than a capacitance of the second link. The application of adjustments as described herein provides calibration, providing better matching of respective channels from the first communication circuit to the second communication circuit.

Testing of the capacitive channels between the first communication circuit and the second communication circuit as described herein can be achieved in any suitable manner. In one example, during the test mode, the controller inputs a common signal (same signal) for conveyance through each of the first link and the second link.

In further examples, during the test mode, the controller adjusts a sensitivity of a detector circuit disposed in the second communication circuit to determine a mismatch between a first capacitive communication channel including the first link and a second capacitive communication channel including the second link. For example, the detector circuit receives a communication signal derived from applying the common signal to or through each of the first link and the second link. The detector circuit compares the received differential communication signal to a threshold value during the test mode to determine a degree of a parasitic capacitance mismatch between the first link and the second link. Adjustment of the sensitivity of the detector circuit may include temporary adjustment of a magnitude of the threshold value during the test mode to calibration one or more of the capacitive communication channels. Additionally, or alternatively, as further discussed herein, the controller can be configured to adjust a gain of an amplifier circuit amplifying the received communication signal (in the receiver circuit) and compare it to the threshold value (of any desired magnitude) to calibrate the communication system.

In yet further examples as discussed herein, the communication system includes a first capacitor disposed in series between the first link and the adjustment circuit; the communication system further includes a second capacitor disposed in series between the second link and the adjustment circuit. A combination of the first link and the first capacitor reside in the first communication path (such as a first capacitive channel) between the first communication circuit of the second communication circuit. A combination of the second link and the second capacitor reside in the second communication path (such as a second capacitive channel) between the first communication circuit of the second communication circuit. In a similar manner as previously discussed, a combination of the first communication path and the second communication path support conveyance of a differential signal during the non-test mode. Inclusion of the first capacitor and the second capacitor in the communication paths blocks conveyance of DC components of a respective differential signal while passing AC components of the differential signal during the non-test mode. Thus, each of the capacitive communication channels as discussed herein may include one or more DC blocking capacitors.

In still further examples, application of the adjustments during the non-test mode may reduce a difference in signal propagation delay over the first capacitive channel including the first link and a second capacitive channel including the second link. In other words, the calibration provided during the non-test mode as described herein may provide better matching of the first capacitive channel and the second capacitor channels such that the signal propagation delay is substantially the same for each of the capacitive channels. In further examples, note that the calibration as discussed herein also results in better matching of a transfer function associated with the first capacitive communication channel to a transfer function of the second capacitive communication channel.

Note further that the communications system and corresponding links as discussed herein can be implemented via inductor/inductive circuit paths instead of capacitive circuit paths. For example, the first link may be disposed in a first inductive channel between the first communication circuit and the second communication circuit; and the second link may be disposed in a second inductive channel between the first communication circuit and the second communication circuit. In such an instance, the combination of the first inductive channel and the second inductive channel are configured to support the conveyance of the respective differential signal during the non-test mode.

Thus, techniques as discussed herein are beneficial over conventional systems. For example, the calibration of capacitive channels as described herein reduces the chance that a transient ground condition (such as a difference and ground between the first communication circuit and the second communication circuit) causes improper settings of an output of the second communication circuit, providing more accurate transmission of data through the communication system even during transient conditions.

These and other more specific concepts are disclosed in more detail below.

As discussed herein, techniques herein are well suited for use in the field of communications. However, it should be noted that this disclosure is not limited to use in such applications and that the techniques discussed herein are well suited for other applications as well.

Additionally, note that although each of the different features, techniques, configurations, etc., herein may be discussed in different places of this disclosure, it is intended, where suitable, that each of the concepts can optionally be executed independently of each other or in combination with each other. Accordingly, the one or more present inventions as described herein can be implemented and viewed in many different ways.

Also, note that this preliminary discussion herein purposefully does not specify every implementation and/or incrementally novel aspect of the present disclosure or claimed invention(s). Instead, this brief description only presents general implementations and corresponding points of novelty over conventional techniques. For additional details and/or possible perspectives (permutations) of the invention(s), the reader is directed to the Detailed Description section (which is a summary of possible implementation and operations) and corresponding figures of the present disclosure as further discussed below.
FIG. 1 is an example general diagram of a communication system and corresponding transmitter-receiver communication channel pairs operating in first data flow mode as disclosed herein.
FIGS. 2A and 2B are example diagrams illustrating variation in links as disclosed herein.
FIG. 3 is an example general diagram of a communication system and corresponding transmitter receiver pairs operating in second data flow mode as disclosed herein.
FIG. 4 is an example diagram illustrating a communication system including a controller to implement calibration as discussed herein.
FIG. 5 is an example diagram illustrating details of a receiver circuit as disclosed herein.
FIG. 6 is an example timing diagram of signals as discussed herein.
FIG. 7 is an example diagram illustrating occurrence of a transient condition and effect on mismatched capacitive channels prior to calibration as disclosed herein.
FIG. 8 is an example diagram illustrating a demodulator disposed in a second communication circuit as disclosed herein.
FIG. 9 is an example diagram illustrating a demodulator and comparator disposed in a second communication circuit as disclosed herein.
FIG. 10 is an example diagram illustrating implementation of threshold adjustments to increase sensitivity of a receiver as described herein.
FIG. 11 is an example diagram illustrating implementation of threshold adjustments to increase sensitivity of a receiver as described herein.
FIG. 12 is an example diagram illustrating implementation of sensitivity/threshold adjustment to support calibration as described herein.
FIG. 13 is an example diagram illustrating computer processor hardware and related software instructions that execute methods as described herein.
FIG. 14 is an example diagram illustrating of a method as discussed herein.

The foregoing and other objects, features, and advantages of the invention will be apparent from the following more particular description of preferred implementations herein, as illustrated in the accompanying drawings in which like reference characters refer to the same parts throughout the different views. The drawings are not necessarily to scale, with emphasis instead being placed upon illustrating the implementations, operations, principles, concepts, etc.

An example apparatus as discussed herein includes a first communication circuit and a second communication circuit. A first link disposed in a first capacitive channel (path) and a second link disposed in a second capacitive channel (path) of the communication system support conveyance of a respective differential signal from the first communication circuit to the second communication circuit during a non-test mode. A controller controls the communication system to temporarily operate in a test mode to facilitate communications in the non-test mode. For example, while in the test mode, the controller determines adjustment settings to an impedance adjustment circuit of the communication system to provide better matching of the first capacitive channel and the second capacitive channel. Subsequent to the test mode and calibration, application of the adjustment settings (i.e., adjustments) to the first capacitive channel and the second capacitive channel reduce effects of a parasitic capacitance mismatch associated with at least the first link and the second link. The better matching of the first capacitive channel to the second capacitive channel via the adjustments as described herein provides higher quality data transfers via a differential signal transmitted over a combination of the first capacitive channel and the second capacitive channel, preventing or reducing improper data signals during transient ground reference conditions.

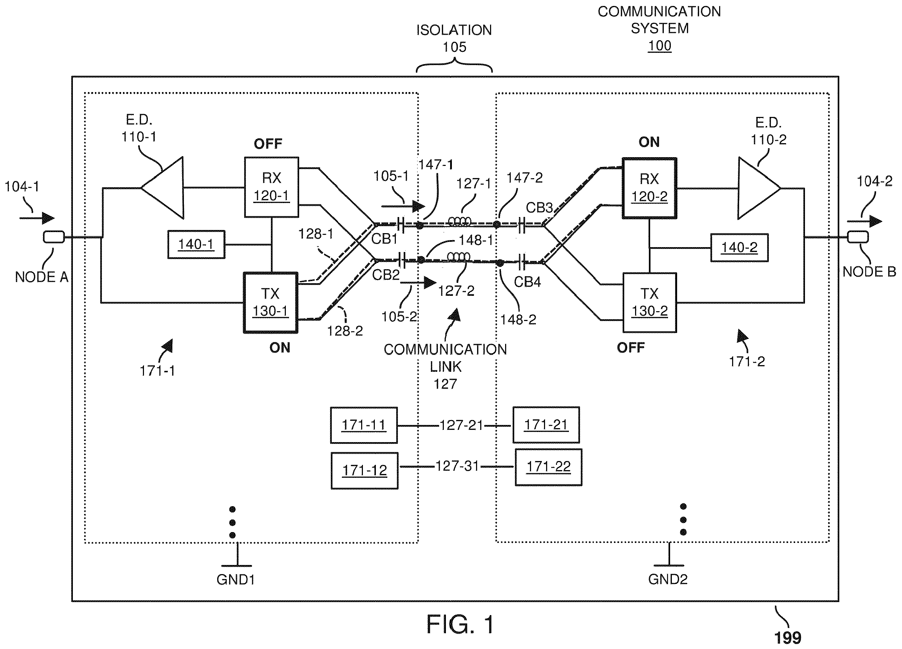

Now, more specifically, FIG. 1 is an example general diagram of a communication system and corresponding transmitter receiver pair operating in a first data flow mode (downstream) as disclosed herein.

As shown, the communication system 100 includes communication circuit 171-1 (transceiver pair) and communication circuit 171-2 (transceiver pair) disposed on the substrate 199. Note that the implementation of substrate 199 is not necessary as the communication circuit 171-1 and the communication circuit 171-2 can be disparately located with respect to each other without being affixed to a common substrate 199.

Thus, the first communication circuit 171-1 and the second communication circuit 171-2 are part of a respective communication system 100. The first communication circuit 171-1 and the second communication circuit 171-2 may or may not be affixed to a common substrate 199.

Each of the communication circuit 171-1 and the communication circuit 171-2 include multiple components supporting conveyance of data between each other. For example, the communication circuit 171-1 includes controller 140-1. The controller 140-1 controls whether the communication circuit 171-1 is set to a transmitter mode of communicating data via signals 105 (such as a differential signal including signal 105-1 and signal 105-2) to the communication circuit 171-2 or whether it is set to a receiver mode of receiving data signals from the communication circuit 171-2.

Similarly, the communication circuit 171-2 includes controller 140-2. The controller 140-2 controls whether the communication circuit 171-2 is set to a transmitter mode of communicating data via signals to the communication circuit 171-1 or whether it is set to a receiver mode of receiving data (such as via differential signal 105) from the communication circuit 171-1.

As further shown in FIG. 1, the controller 140-1 controls the transmitter 130-1 and corresponding circuitry to be in an ON-state while controller 140-1 controls the receiver 120-1 and corresponding circuitry to be in an OFF-state. This causes the communication circuit 171-1 to be set to a transmitter mode of communicating data to the communication circuit 171-2 as shown in FIG. 1.

Further in FIG. 1, the controller 140-2 controls the transmitter 130-2 and corresponding circuitry to be in an OFF-state while the controller 140-1 controls the receiver 120-1 and corresponding circuitry to be in an ON-state.

The pair of links 127 (including link 127-1 and link 127-2) provide connectivity associated with the capacitive communication paths 128 (capacitive communication path 128-1 and capacitive communication path 128-2) extending between the transmitter 130-1 and the receiver 120-2. The capacitive communication path 128-1 of the communication path 128 includes a series connectivity of capacitor CB1, link 127-1, and capacitor CB3 between the transmitter 130-1 and the receiver 120-2.

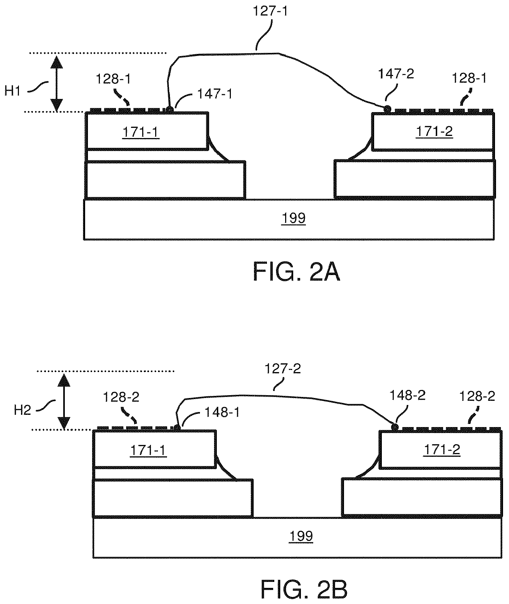

The capacitive communication path 128-2 of the communication path 128 includes a series connectivity of capacitor CB2, link 127-2, and capacitor CB4 between the transmitter 130-1 and the receiver 120-2. As shown in FIG. 2, the link 127-1 and the link 127-2 are susceptible to mismatch, resulting in RLC (resistance, inductors, and/or capacitance) mismatch between the first capacitive communication path 128-1 and the second capacitive communication path 128-2.

FIGS. 2A and 2B are example diagrams illustrating variation in links as disclosed herein.

In this example, the link 127-1 (FIG. 2 A) such as a wire bond or other suitable form of electrically conductive path in communication path 128-1 (i.e., circuit path) is physically a different shape and has different dimensions than the link 127-2 (FIG. 2B) such as a wire bond or other suitable form of electrically conductive path in circuit path 128-2 (i.e., circuit path). For example, the link 127-1 has a respective height of H1, while the link 127-2 has a height of H2. The shape of link 127-1 is different than the shape of 127-2.

Referring to Figure 2A, link 127-1 connects a first node 147-1 of the first communication circuit 171-1 to a first node 147-2 of the second communication circuit 171-2. Referring to Figure 2B, link 127-2 connects a second node 148-1 of the first communication circuit 171-1 to a second node 148-2 of the second communication circuit 171-2.

The variation in the shape such as height for the dimensions associated with links 127, attributes of connecting different ends of the respective link 127 to nodes of a corresponding communication circuit, etc., result in different parasitic capacitances associated with each of the links 127.

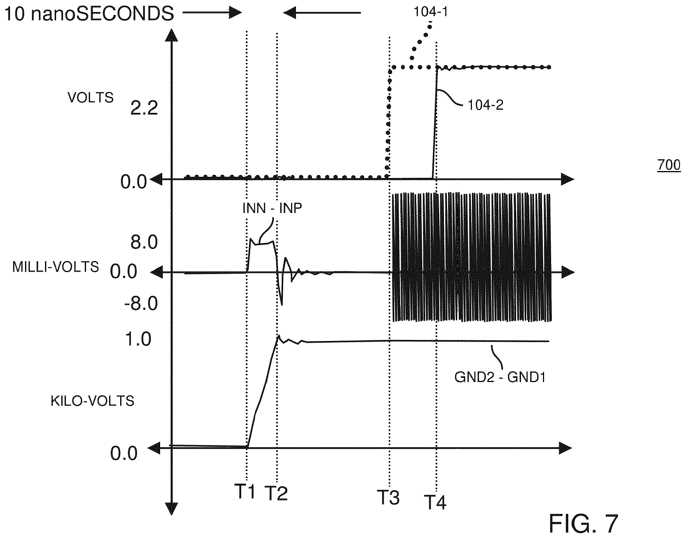

Note that the mismatch in parasitic capacitances (and/or inductances, resistances, etc.) associated with each of the link 127-1 (also part of communication path 128-1) and link 127-2 (also part of communication path 128-1) in respective communication paths (a.k.a., circuit paths) is undesirable because this causes a mismatch in the attributes (such as resistors, capacitors, inductors) associated with communication path 128-1 and communication path 128-2, degrading signal quality of communications transmitted over the communication paths 128. As shown in FIG. 7, the mismatch of the capacitive communication path 128 and corresponding capacitive communication channels may result in detection of transmitted data signal when no signal is transmitted during a transient difference in ground references GND1 and GND2.

Referring again to FIG. 1, during non-test mode operation in a downstream mode from the communication circuit 171-1 to the communication circuit 171-2, the communication circuit 171-1 receives signal 104-1 at node A. The transmitter 130-1 converts the received input signal 104-1 into signal 105-1 (part of a differential signal 105) communicated over the communication path 128-1 to the receiver 120-2. As previously discussed, communication path 128-1 includes series disposed DC blocking capacitor CB1 and DC blocking capacitor CB3. As their name suggests, these blocking capacitors allow the AC component of the signal 105-1 transmitted by the transmitter 130-1 to pass along the communication path 128-1 to the receiver 120-2. As further illustrated, the communication path 128-1 may include some amount of parasitic inductance.

In general, the circuitry associated transmitter 130-1 can be configured to control a respective resonant frequency (or carrier frequency) of a modulated signal derived from the input signal 104-1; such a signal is communicated as signal 105-1 over the communication path 128-1. As further discussed herein, the receiver 120-2 includes a respective bandpass filter through which the received signal 105-1 passes to an envelope detector 110-2. The circuitry associated with the receiver 120-2 controls respective settings of a bandpass filter. In one implementation, it is desired that the carrier frequency of the signal 105-1 as controlled by circuit of transmitter 130-1 matches a peek bandpass carrier frequency disposed in the receiver 120-2 to provide the best gain of the received signal.

As shown in as previously discussed, the communication path 128 may be implemented as a differential communication link including multiple capacitive communication channels supporting differential signals. For example, the communication path 128 may include a pair of conductive paths (communication path 128-1 and communication path 128-2) extending between the first communication circuit 171-1 and the second communication circuit 171-2. Communication path 128-2 includes series disposed DC blocking capacitor CB2 and DC blocking capacitor CB4. As their name suggests, these blocking capacitors allow the AC component of the signal 105-2 transmitted by the transmitter 130-1 to pass along the communication path 128-2 to the receiver 120-2. As further illustrated, the communication path 128-2 may include some amount of parasitic inductance.

The pair of conductive paths 128 convey the differential signals 105-1 and 105-2 (including a respective data is captured by the input signal 104-1). For example, the communication path 128-1 conveys the signal 105-1; the communication path 128-2 conveys the signal 105-2. Thus, communication link 128 may include a first conductive path and a second conductive path extending between the first communication circuit and the second communication circuit.

In the second communication path 128-2 of communication path 128, the components of transmitter 130-1 control a respective resonant frequency (or carrier frequency) of a modulation signal 105-2 derived from the input signal 104-1; such a signal is communicated as signal 105-2 over the communication path 128-2 as previously discussed. As further discussed herein, the receiver 120-2 can be configured to include a respective bandpass filter through which the received signal 105-2 passes to the envelope detector 110-2. The circuitry of the receiver 120-2 controls respective settings (such as a band-pass resonant frequency) of the bandpass filter that receives signal 105-2. In one implementation, it is desired that the carrier frequency of the signal 105-2 as controlled by the circuitry of receiver 120-2 matches a peak bandpass carrier frequency disposed in the receiver 120-2 to provide the best gain of the received signal 105-2.

In accordance with further examples, the first communication circuit 171-1 and corresponding circuit components may be galvanically isolated with respect to the second communication circuit 171-2 and corresponding circuit components. For example, the circuitry in communication circuit 171-1 may be referenced with respect to ground reference voltage/potential (GND1); the circuitry in communication circuit 171-2 may be referenced with respect to ground reference voltage/potential (GND2). Note that the different ground reference voltage potentials (i.e., GND1 versus GND2) are susceptible to experiencing large and/or frequent variations such as up to or greater than 500 volts. Again, see FIG. 7. Referring again to FIG. 1, note that the configuration of the communication system 100 corresponding components supports robust communications even in conditions in which the communication circuitry experiences large differences between ground voltage potentials.

Note further that the communication path 128 and any portion thereof can be implemented in any suitable manner. For example, the communication link 128 may be implemented or include respective electrically conductive paths (such as bond wires, twisted pair wires, etc.) of any suitable length. In still further instances of the communication system 100 as described herein, a length of the link 127-1 and link 127-2 disposed between the first communication circuit 171-1 and the second communication circuit 171-2 may be less than Y inches or any other suitable value, where Y is a value such as 1/16, 1/8, ¼, ½, ¾, 1, 2, 3, 4, 5, 6, 7, 8, 9, 10, etc. As previously discussed, the length of each of the communication links 127 may be greater than the value Y.

Note that the communication system 100 as discussed herein can be implemented in any suitable manner. For example, the communication circuit 171-1 can be implemented as a single-chip solution including one or more differential and bidirectional transceivers attached to a substrate and SiO2 dielectric isolation barrier between 2 metal layers, forming the capacitive channel. Placing one instance of this die (such as communication circuit 171-1) in the transmitter side of the communication system 100 and the other die (such as communication circuit 171-2) in the receiver side of the communication system 100 (rotated 180 degrees) and connecting them in series doubles the effective isolation, increasing a magnitude of a respective breakdown voltage.

Note that the single-chip including the communication circuit 171-1 can include any number of replica transceivers (such as communication circuit 171-11, 171-12, etc.; each being similar to communication circuit 171-1) on the first semiconductor chip. A second semiconductor chip can be configured to include the communication circuit 171-2 and can include any number of replica transceivers (such as communication circuit 171-21, 171-22, etc.; each being similar to communication circuit 171-2) on that same second semiconductor chip. Each of the communication links 127-21, 127-31, etc., is similar to communication link 127 (including link 127-1 and link 127-2). The first semiconductor chip and the second semiconductor chip may be mounted on the same substrate in a manner as shown in FIG. 1. The first semiconductor chip in the second semiconductor chip may be cut from the same wafer.

Thus, all or a portion of the first communication circuit 171-1 may be configured as a first semiconductor chip. In such an instance, the transmitter 130-1 and receiver 120-1 are disposed on the first semiconductor chip. The first semiconductor chip can be configured to include any number of transceivers and corresponding circuitry (such as similar to communication circuit 171-1).

Additionally, note that all or a portion of the communication circuit 171-2 may be configured as a second semiconductor chip. In such an instance, the receiver 120-2 and corresponding circuitry as well as transmitter 130-2 are disposed on a second semiconductor chip. The second semiconductor chip can be configured to include any number of transceivers and corresponding circuitry (such as similar to communication circuit 171-2). Thus, communication system 100 and corresponding communication link between each set of transceivers supports parallel and bidirectional conveyance of data.

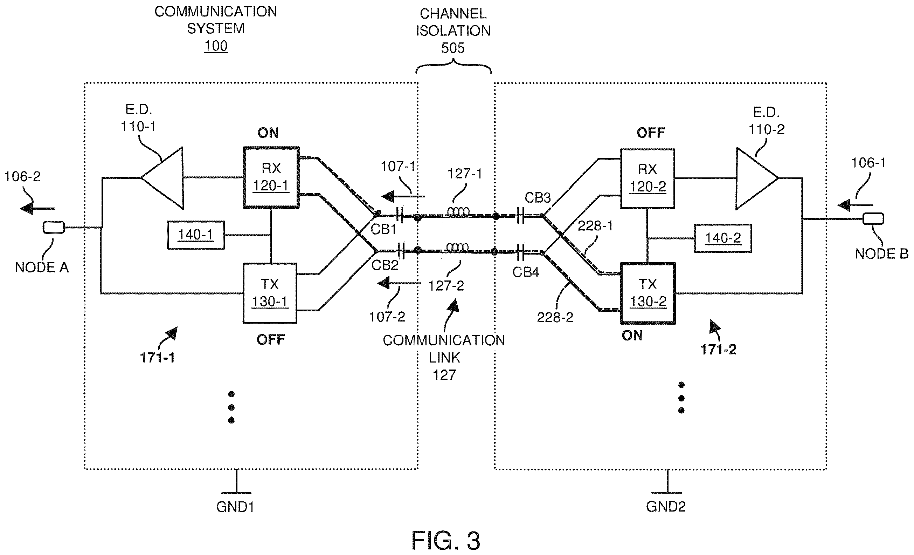

FIG. 3 is an example general diagram of a communication system and corresponding transmitter receiver pair operating in second data flow mode as disclosed herein.

As shown in FIG. 3, the communication path 128 supports bidirectional communications. For example, the controller 140-2 controls the transmitter 130-2 and corresponding circuitry to be in an ON-state while it controls the receiver 120-2 and corresponding circuitry to be in an OFF-state. This causes the communication circuit 171-2 to be set to a transmitter mode of communicating data to the communication circuit 171-1.

Yet further in FIG. 3, the controller 140-1 controls the transmitter 130-1 and corresponding circuitry to be in an OFF-state while it controls the receiver 120-1 and corresponding circuitry to be in an ON-state. This causes the communication circuit 171-1 to be set to a receiver mode of receiving data from the communication circuit 171-2.

During operation in an upstream mode (FIG. 3) from the communication circuit 171-2 to the communication circuit 171-1, the communication circuit 171-2 receives signal 106-1 at node B. The transmitter 130-2 converts the received input signal 106-1 into signal 107-1 communicated over the communication path 228-1 to the receiver 120-1. Communication path 228-1 includes series disposed DC blocking capacitor CB3 and DC blocking capacitor CB1. As their name suggests, these blocking capacitors allow the AC component of the signal 107-1 transmitted by the transmitter 130-2 to pass along the communication path 228-1 to the receiver 120-1. As further illustrated, the link 127-1 may include some amount of parasitic inductance, capacitance, and/or resistance.

In general, circuitry in the transmitter 130-2 controls a respective resonant frequency (or carrier frequency) of a modulation signal derived from the input signal 106-1; such a signal is communicated as signal 107-1 over the communication path 228-1. The receiver 120-1 includes a respective bandpass filter through which the received signal 107-1 passes to an envelope detector 110-1. An inductance of circuitry in the receiver 120-1 controls respective settings of a bandpass filter in the receiver 120-1. In one implementation, it is desired that the carrier frequency of the signal 107-1 substantially matches a peak bandpass carrier frequency setting associated with the receiver 120-1 and corresponding band-pass filter provide the best gain of the received signal 107-1.

As further shown, during operation in an upstream mode (FIG. 3) from the communication circuit 171-2 to the communication circuit 171-1, the communication circuit 171-2 receives signal 106-1 at node B. The transmitter 130-2 converts the received input signal 106-1 into signal 107-2 communicated over the communication path 228-2 to the receiver 120-1. Communication path 228-2 includes series disposed DC blocking capacitor CB4 and DC blocking capacitor CB2. As their name suggests, these blocking capacitors allow the AC component of the signal 107-2 transmitted by the transmitter 130-2 to pass along the communication path 228-2 to the receiver 120-1. As further illustrated, the communication path 228-2 may include some amount of parasitic inductance, capacitance, and/or resistance.

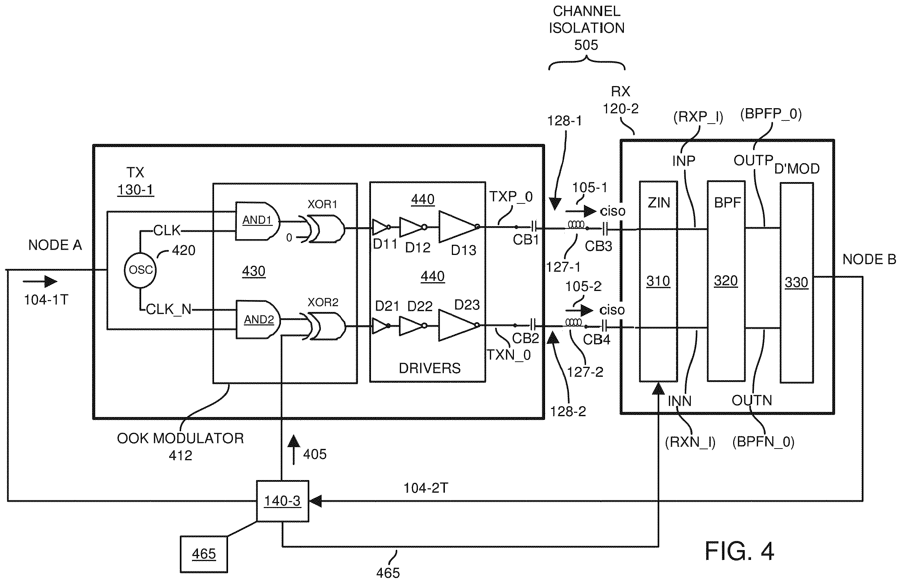

FIG. 4 is an example diagram illustrating a communication system including a controller to implement calibration as discussed herein.

Implementation of the transmitter 130-1 (and related components) may include oscillator 420, modulator 430 (including logic AND1, logic AND2, logic XOR1, and logic XOR2), and drivers 440. Implementation of the receiver 120-2 includes the impedance adjustment circuit 310, bandpass filter 320, and the demodulator 330.

The transmitter 130-1 receives signal 104-1 (or signal 104-1T in a test mode) in a manner as previously discussed. Signal 104-1 (or signal 104-1T) is inputted to the inputs of the logic AND 1 and logic AND2. Signal CLK generated by the oscillator 420 is inputted to the logic AND1; signal CLK_N (inverse state of CLK) generated by the oscillator 420 is inputted to the logic AND2. The output of logic AND1 and the setting zero drives the input of logic XOR1. The output of the logic XOR1 drives the sequence of drivers D11, D12, D13. Driver D13 outputs the corresponding signal 105-1 (or signal TXP_0 in a test mode) to the communication path 128-1 including the capacitor CB1. The output of logic AND2 and the setting of signal 405 drives the input of logic XOR2. Signal 405 from controller 140-3 drives the other input of the logic XOR2. The output of the logic XOR2 drives the sequence of drivers D21, D22, D23. Driver D23 outputs the corresponding signal 105-2 (or TXN_0 in a test mode) to the communication path 128-2 including the capacitor CB2.

In a test mode, controller 140-3 generates the control signal 405 to a logic one state. In such an instance, the signal TXP_0 and signal TXN_0 are substantially the same signal. That is, when input signal 104-1T is a logic high, both signal TXP_0 and TXN_0 are switching in phase with respect to each other at the frequency defined by the OSC (402). Conversely, when input signal 104-1T is a logic low, both signals TXP_0 and TXN_0 are idle in logic low level.

In a non-test mode, the controller 140-3 generates the control signal 405 to a logic low state (0). In such an instance, the signal TXP_0 (105-1) and signal TXN_0 (105-2) are opposite states to form a differential signal in the non-test mode. That is, when the non-test mode input signal 104-1 is a logic high, signal TXP_0 and TXN_0 are 180° out of phase with respect to each other at the frequency defined by the OSC (402). Conversely, when the non-test mode input signal 104-1 is a logic low, signal TXP_0 and TXN_0 are a logic low.

Thus, according to one configuration, the On-OFF Keying modulator 430 is performed by a simple logic AND combination of the input signal 104-1, received from the input pin (node A), with the oscillator 420 output signal defined as CLK and CLK_N. As previously discussed, the CLK_N signal is 180 degrees out of phase with respect to CLK signal.

As further shown, the receiver 120-2 includes impedance adjustment circuit 310, bandpass filter 320, and modulator 330. During the test mode, the controller 140-3 generates the signal 405 to the logic 1. Further during the test mode, the controller 140-3 generates the control signal 104-1T inputted to node A of the transmitter 130-1. Controller 140-3 monitors the node B and corresponding signal 104-2T to determine how to control settings of the impedance adjustment circuit 310. Additional details of calibrating and/or setting the impedance adjustment circuit 310 are further discussed below.

As discussed herein, common mode transient (CMT) surge is one of the main challenges in digital galvanic isolated systems such as communication system 100. The key element of the CMT surge that impacts the correct functionality of a differential communication system 100 is the conversion of the common-mode into differential-mode due to unbalanced (unmatched) elements in each of the capacitive communication channels 128. These mismatches can be present on the transmitter, receiver, and/or in the isolation channel 505 (including link 127-1 and link 127-2) that separates them. As discussed herein, when there is a delay in one capacitive communication channel with respect to another capacitive communication channel in a capacitive communication channel pair, there is a differential signal even when the magnitude of the transfer function of each capacitive communication channel is the same, which results in potential errors. However it is noted that the capacitive communication channels are two different circuits (and may be partially or completely mismatched) that have the same delay, but different magnitude of the transfer function, which would also result in potential communication errors as well. The techniques of providing better matching as discussed herein ensures that both transfer functions associated with the circuits are substantially equal as discussed herein and hence do not produce differential signals when a common-mode disturbance occurs.

When the source of mismatch is present on the transmitter or receiver side, trimming procedures can be implemented on both dies (transmitter 130-1 and receiver 120-2) to eliminate or at least reduce the source of unbalance. Or the mismatch present, there can be guaranteed by design to be small enough to be neglected. However, as previously discussed, the isolation channel entangles elements that are controlled by the back-end of a respective communication CHIP.

Techniques herein include a novel trimming methodology to reduce the mismatch on differential capacitive channels (such as communication path 128-1 and communication path 128-2). The strategy is attained through the configuration of the TX/RX circuits into a design for test (DFT) mode which allows the measurement of the channel mismatch and subsequent adjustment.

One aspect of implementing capacitive channel matching is based on the receiver block structure for capacitively coupled transceiver.

The top-level block diagram of the capacitive communication system is shown in FIG. 4. During normal operation such as a non-test mode, whenever a signal 104-1 or 104-1T is applied to the input pin (node A), the ON-OFF Keying (OOK) modulator 412 generates two clock signals (txp & txn) that are issued to the driver stage 440. These signals, which are 180 degrees out of phase with respect to each other, are then amplified by the driving stage 440 and finally applied to the capacitive isolated channel (signal txp_o is applied to the communication path 128-1 and signal txn_o is applied to the communication path 120-2).

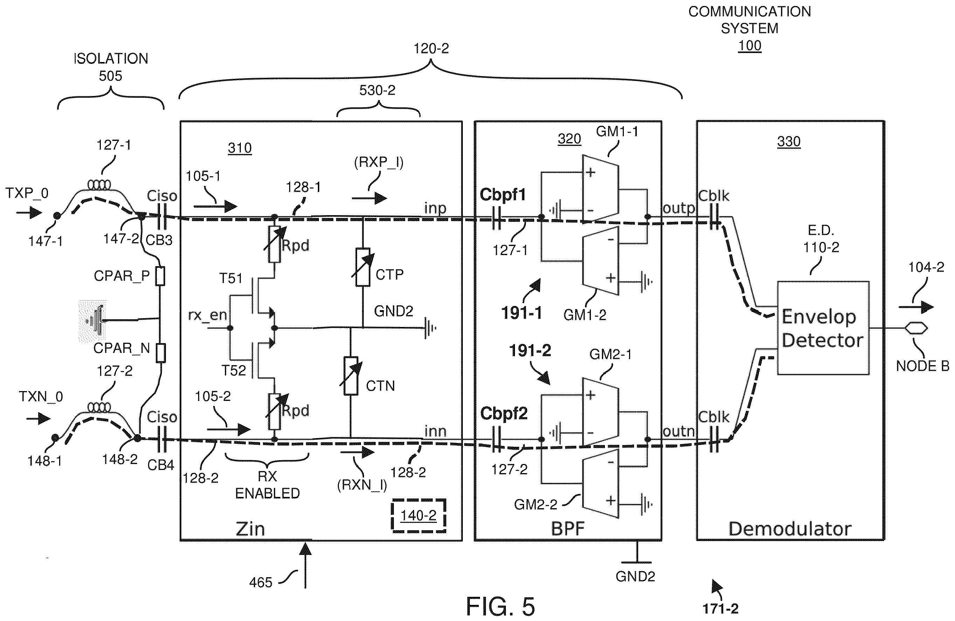

In the receiver 120-2, the impedance adjustment circuit 310 (such as input matching impedance block Zin) shapes the received signal accordingly to the values of all RLC elements present in the network formed by the isolation capacitors (such as Ciso, see also FIG. 5 for details), wirebonds, parasitic capacitors (such as Cpar_p & Cpar_n, see FIG. 5 for details), trimming capacitors (such as ctp & ctn, see FIG. 5 for details) and pull-down resistors (such as Rpd, see FIG. 5 for details). Assuming that all elements of the above-mentioned RLC network in each different communication path are perfectly or nearly matched, the transmission of a common-mode signal, txp_o in phase with txn_o during a test mode, would produce no differential signal (OUTP - OUTN) at the receiver side. In such an instance, when the impedance adjustment circuit 310 is properly calibrated, the system 100 is intrinsically robust against any CMT surges and this is exactly the target performance of the system in normal operation mode (non-test mode).

However, note that no system is perfectly matched and the mismatch present in the RLC network of each communication path 128-1 and 128-2 can produce a differential signal on the receiver side during CMT surges, as depicted in FIG. 7 between time T1 and time T2. During the CMT event (between time T1 and time T2), this differential signal generated due to the mismatch in the RLC network can be detected at the output of a respective envelope detector 110-2, which is part of the demodulator 330, and can be propagated to the output node B if no trimming on the demodulator 330 is performed.

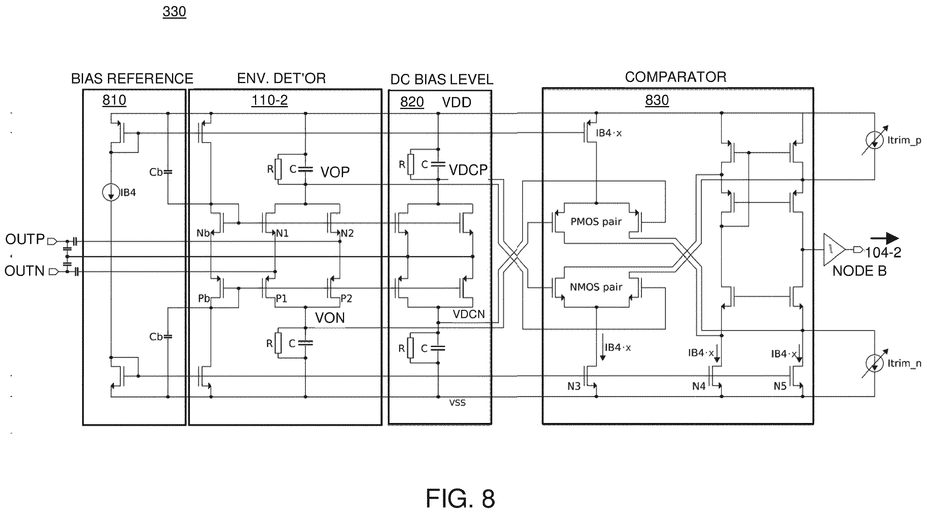

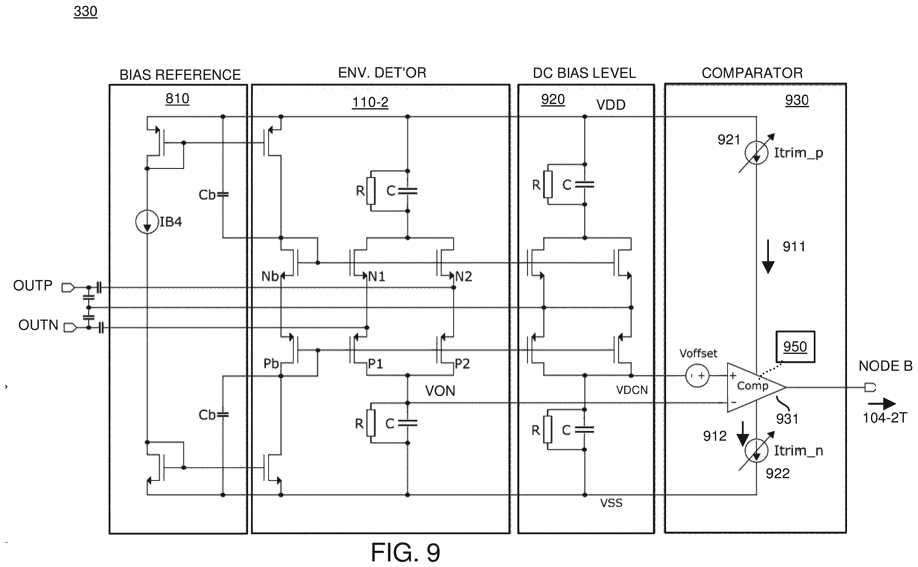

To avoid the above-mentioned scenario (such as mismatch and erroneous generation of a respective differential signal based on transient ground conditions), the demodulator 330 as further discussed herein can be equipped with trimming capability to define the threshold level of the comparator (see FIGS. 8 and 9), which is used the set the proper threshold. Although the system 100 is robust enough to survive the disturbance propagated in the receiver channel all the way to the envelope detector output, having a calibration procedure that reduces this disturbance at its source is desired, since it results in a more robust communication system 100.

FIG. 5 is an example diagram illustrating details of a receiver circuit as disclosed herein.

The controller 140-2 and corresponding circuitry including transistor T51 and transistor T52 controls the operation of the receiver 120-2 in the receiver mode. For example, the controller 140-2 sets signal rx_en to a logic high, connecting the resistor Rpd1 between the circuit path 128-1 and ground reference GND2. Setting of signal rx_en to a logic high also causes connection of the resistor Rpd2 between the circuit path 128-2 and ground reference GND2.

As shown, the active inductor 191-1 in communication path 128-1 is implemented in the band-pass filter 320 via a combination of transconductance amplifier GM1-1 and transconductance amplifier GM1-2 as well as capacitor Cbpf1. Capacitor Cbpf1 is associated with band-pass filter 320. As its name suggests, the capacitor Cblk in the demodulator 330 is a DC blocking capacitor. The inductance of the active inductor 191-1 and the bandpass capacitor Cbpf1 controls a setting of the frequencies associated with the bandpass filter response 320 and, more specifically, which frequencies associated with the received signal 105-1 (or signal TXP_0) are passed along communication path 128-1 through to the envelope detector 110-2.

Similarly, the active inductor 191-2 in communication path 128-2 is implemented in the band-pass filter 320 via a combination of transconductance amplifier GM2-1 and transconductance amplifier GM2-2 as well as capacitor Cbpf2. Capacitor Cbpf2 is associated with band-pass filter 320. As its name suggests, the capacitor Cblk in the demodulator 330 is a DC blocking capacitor. The inductance of the active inductor 191-2 and the bandpass capacitor Cbpf2 control a setting of the frequencies associated with the bandpass filter response 320 and, more specifically, which frequencies associated with the received signal 105-2 (or signal TXN_0) are passed along communication path 128-2 through to the envelope detector 110-2.

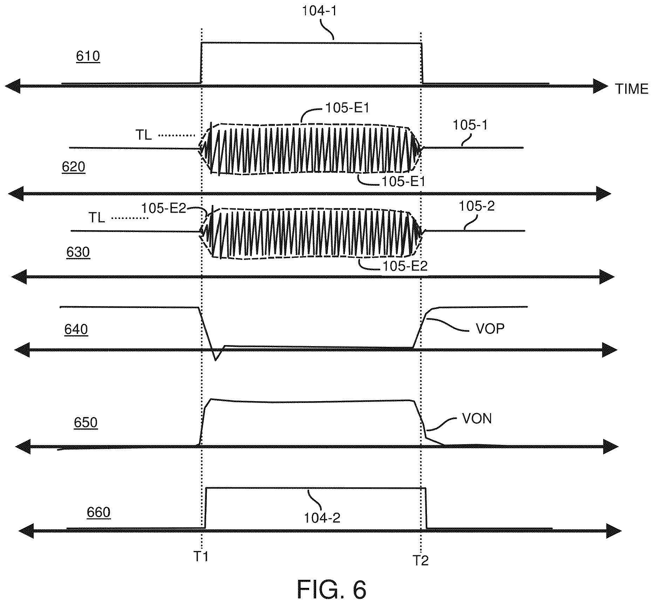

FIG. 6 is an example timing diagram of signals during a non-test mode as disclosed herein.

Assume that the controllers (140-1, 140-2, 140-3), during a non-test mode, operate the communication circuit 171-1 in a transmitter mode and communication circuit 171-2 and receiver mode. As shown in FIG. 6 illustrates operation of the circuit to convey data from the input node A to the output node B during the non-test mode.

For example, graph 610 illustrates timing of input signal 104-1, which is logic high between time T1 and T2 and otherwise logic low.

Graph 620 illustrates timing associated with transmitted signal 105-1 and operation at a resonant frequency between time T1 and T2 when signal 104-1 is a logic high. Note that the resonant frequency associated with the transmitter 130-1 and corresponding transmitted signal 105-1 is substantially greater than the frequency of signal 104-1. Via monitoring of the signal 105-1, the envelope detector 110-2 detects the envelope 105-E1.

Graph 630 illustrates timing associated with signal 105-2 and operation at a resonant frequency between time T1 and T2 when signal 104-1 is a logic high. Note again that the resonant frequency associated with the transmitter 130-1 and corresponding transmitted signal 105-2 is substantially greater than the frequency of signal 104-1. Via monitoring of the signal 105-2, the envelope detector 110-2 (1120) detects the envelope 105-E2.

Graph 640 illustrates the magnitude of voltage Vop over time. Graph 650 illustrates the magnitude of voltage Von over time. The signal 105-1 and 105-2 are applied to the envelop detector 110-2 in a differential way producing VOP and VON together.

Graph 660 illustrates the generation and output of the corresponding signal 104-2 from the communication circuit 171-2. Thus, detection of the envelope 105-E1 between time T1 and T2 associated with the signal 105-1 and detection of the envelope 105-E2 associated with signal 105-2 between time T1 and T2 results in the envelope detector generating the output signal 104-2 from node B (whose magnitude is a logic high during conditions in which the envelopes are detected), which is a reproduction of the original signal 104-1.

As previously discussed, it is desirable to provide impedance matching of the communication path 128-1 to the communication path 128-2 application of the adjustments 465 (adjust information or adjustment settings) to the adjustment circuit 310. The following FIGS. and corresponding text describe multiple ways in which to provide better impedance matching of each of the communication paths 128-1 and 128-2 via settings applied to the impedance adjustment circuit 310 (a.k.a., ZIN) of FIG. 5.

FIG. 7 is an example diagram illustrating occurrence of a transient condition and effect on mismatched capacitive channels as disclosed herein.

Graph 700 illustrates operation of the communication system 100 in a non-test mode to illustrate undesirable signal disturbance when the first communication path 128-1 is not matched to the second communication path 128-2.

As shown, the difference voltage between the ground reference GND1 and ground reference GND2 may vary substantially over time. For example, in graph 700, the difference between ground reference GND2 and ground reference GND1 rapidly changes during a respective transient condition between time T1 and time T2. In such an instance, between time T1 and time T2, the voltage difference between signal INN and signal INP (signal INN - INP) experiences a disturbance as well.

Techniques herein include calibrating the impedance adjustment circuit 310 with adjustment settings 465 in FIG. 5 to provide better impedance matching of communication path 128-1 and communication path 128-2 to reduce the disturbance associated with different signal INN - INP during transient conditions.

FIG. 8 is an example diagram illustrating a demodulator disposed in a second communication circuit as disclosed herein.

As previously discussed in FIG. 5, the demodulator 330 receives the signal OUTP conveyed over communication path 128-1 and signal OUTN conveyed over communication path 128-2. In this example of FIG. 8, the demodulator 330 includes bias reference circuit 810, envelope detector 110-2, DC bias level circuit 820, and comparator 830.

FIG. 9 is an example diagram illustrating a demodulator and comparator disposed in a second communication circuit as disclosed herein.

In this example, the demodulator 330 includes bias reference circuit 810, envelope detector 110-2, DC bias level circuit 920, and comparator 930 (such as equivalent of comparator 830). The comparator 930 is configured to monitor the differential voltage VON - VDCN, which is generated based on the signal OUTP conveyed over communication path 128-1 and signal OUTN conveyed over communication path 128-2.

Note that the settings of the threshold level 950 associated with the comparator 931 is based upon a magnitude of the trim current 911 provided by the current source 921 and the magnitude of the trim current 912 provided by the current source 922 to the comparator 931. During the non-test mode, the threshold level 950 is relatively high. However, during the test mode, the controller 140-3 reduces the magnitude of the threshold level 950 in order to determine appropriate settings (such as settings for resistor RPD1, capacitor CTP, resistor RPD2, capacitor CTN, etc., as previously discussed with respect to FIG. 5) for the impedance adjustment circuit 310.

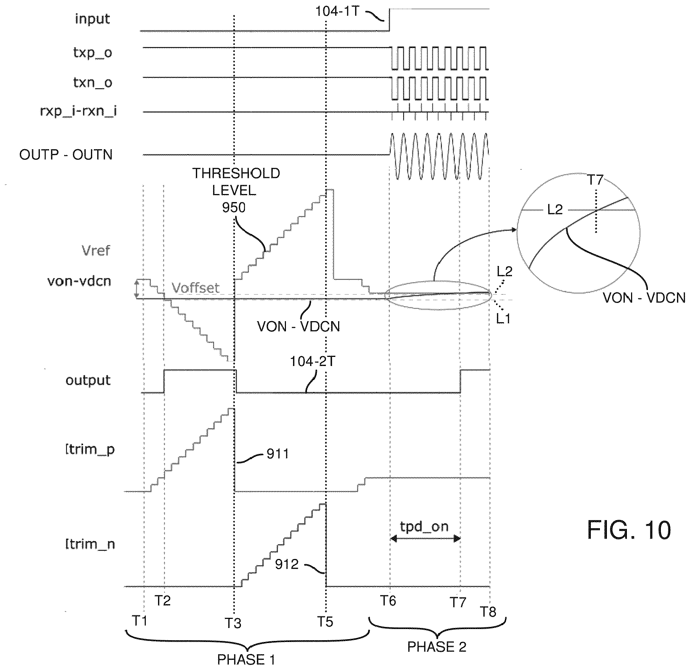

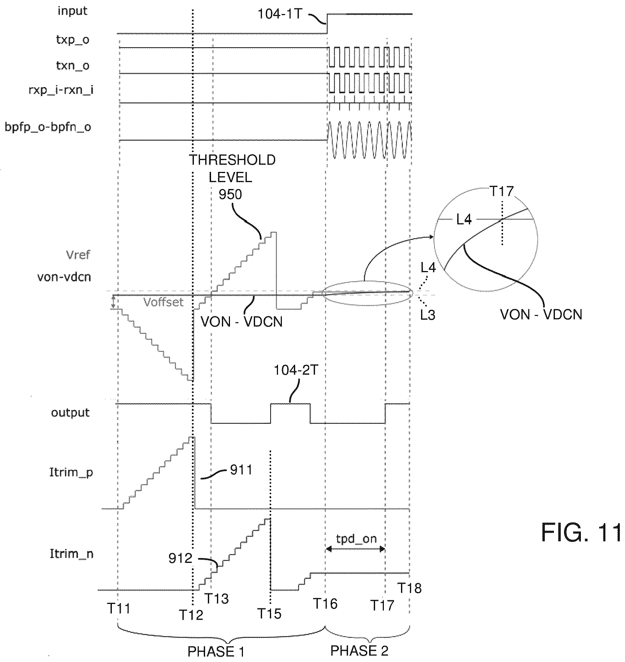

An example of adjusting the threshold level 950 to calibrate the corresponding impedance adjustment circuit 310 (FIG. 3) is shown in FIGS. 10 and 11.

FIG. 10 is an example diagram illustrating implementation of threshold adjustments to increase sensitivity of a receiver as described herein.

Applying a ground shift of hundreds of volts between the GND1 of transmitter circuit 130-1 and GND2 of the receiver circuit 120-2 may be difficult to implement in a test condition. However, by changing the transmitter circuit 130-1 to send pulses on positive and negative output terminals of the isolation channel 505 (pulses that are in phase with each other), a scaled-down version of the CMT surge pattern can be produced and applied to the receiver circuit 120-2 in a safe and controlled manner.

For example, FIG. 10 illustrates waveforms associated with operating the transmitter circuit 130-1 and the receiver circuit 120-2 in a test mode including 2 phases.

In the first phase, between time T1 and time T6, the comparator 931 offset error (Voffset) of the demodulator 330 (in the receiver circuitry 120-2) is canceled out by the controller 140-3 adjusting the amount of trim current 911 (a.k.a., Itrim_p) and 912 (Itrim_n) being pulled or pushed to the comparator 931. During this offset cancelation phase one, no signal is being transmitted from the transmitter side (i.e., the input signal 104-1T is set to 0), which allows the detection of the comparator trip point by the controller 140-3 via observing only the output signal 104-2T of the comparator 931.

Between time T1 and time T3 in FIG. 10, while the magnitude of the differential signal VON - VDCN is voltage level L1, the controller 140-3 increases (such as steps) the magnitude of the trim current 911 supplied to the comparator 931 while the trim current 912 is constant. In such an instance, this causes the threshold level 950 to reduce a magnitude between time T1 and time T3. During this time, the controller 140-3 monitors a magnitude of the output signal 104-2T for a change from a logic 0 to a logic 1. In this example, the controller 140-3 detects a respective transition of the output signal 104-2T from logical low to logic high at time T2. The controller 140-3 records this value.

Between time T3 and time T5, while the magnitude of the differential signal VON - VDCN is voltage level L 1, the controller 140-3 increases the magnitude of the trim current 912 sunk from the comparator 931 while the trim current 911 is constant. In such an instance, this causes the threshold level 950 to increase a magnitude between time T3 and time T5. During this time, the controller 140-3 monitors a magnitude of the output signal 104-2T for a change from a logic 0 to a logic 1. In this example, the controller 140-3 does not detect a respective transition of the output signal 104-2 T from logical to logic high between time T3 and T5.

In this example, the trip point is determined as values of trim current 911 and value of the trim current 912 applied just prior to time T2 during calibration testing. The controller 140-3 stores these trip settings for the second phase (Phase 2).

As mentioned, this procedure is generally a scaled-down version of a CMT event. Hence, the first phase is implemented to increase the sensitivity of the comparator 931 by lowering a magnitude of the threshold level 950 to level L2 in the test mode.

In the second phase, the controller 140-3 applies the stored settings to support threshold level 950 equal to level L2. In other words, the controller 140-3 applies the stored settings of trim current 911 and trim current 912 to the comparator 931 to set the threshold level 950 to voltage level L2. The controller 140-3 also operates the transmitter circuit 130-1 in the test mode by setting the dft_mode signal (i.e., signal 405 of FIG. 4) to a logic high level; the input signal 104-1T is modulated with the carrier, produced by the oscillator 420, and produces two high-frequency signals such as signal TXP_0 inputted to capacitor CB1 and signal TXN_0 inputted to capacitor CB2. The signal TXP_0 is substantially the same as signal TXN_0. This common-mode signal (of TXP_0 and TXN_0) is transmitted over the channel RLC network (the mismatched capacitive communication paths 128-1 and 128-2).

As shown and as previously discussed in FIG. 5, the communication path 128-1 includes the parasitic capacitance CPAR_P and CPAR N. The magnitude of the parasitic capacitances CPAR_P and CPAR_N may be any suitable values. In one example, the magnitude of the parasitic capacitance CPAR_P is 30 femto-farads and the capacitance of the parasitic capacitance CPAR_N is 45 femto-farads; in another example, the magnitude of the parasitic capacitance CPAR_P is 35 femto-farads and the capacitance of the parasitic capacitance CPAR_N is 30 femto-farads; in another example, the magnitude of the parasitic capacitance CPAR_P is 30 femto-farads and the capacitance of the parasitic capacitance CPAR_N is 40 femto-farads; and so on.

The difference between CPAR_P and CPAR_N results in a small differential voltage signal between the RXP_I (INP) and RXN_I (INN) terminals of the receiver circuit 120-2. Since this common-mode perturbation is generated by the transmitter oscillator 420, it will possess the carrier frequency, hence it will be amplified by the BPF 320 on the receiver circuit 120-2 (bpfp_o-bpfn_o) or (OUTP - OUTN). This amplified differential signal (VON-VDCN) is integrated by the envelop detector 110-1 until the integrated voltage is detected (VON-VDCN crosses the threshold level 950) by the demodulator comparator 931 (at time T7), which had its sensitivity increased in phase 1 via the stored trim current settings. Since the gain of the BPF 320 is limited, the time propagation delay (TPD_ON) between T6 and T7 is a measure of how high the differential input signal is at the receiver side (rxp_i-rxn_i). As discussed above, the amount of differential signal due to the common-mode disturbance in this particular scenario is a measure of how much RLC mismatch is present between the communication path 128-1 and communication path 128-2. Therefore, determining TPD_ON under these test conditions is equivalent to measuring the RLC channel network mismatch.

During the second phase, via trial and error, the controller 140-3 repeatedly sets the capacitor CTP in capacitor CTN (see Fig. 5 as well) of the adjustment circuit 310 to different values to determine which of multiple different possible settings of CTP and CTN provide the longest delay time TPD_ON. The longer this delay time, the lower the impedance mismatch between the capacitive communication path 128-1 and the capacitive communication path 128-2, providing best transient and data error immunity.

As a first example, assume that the capacitance of the parasitic capacitor CPAR_P is 45 femto-Farads and the parasitic capacitance of the capacitor CPAR_N is 30 femto-Farads. This results in an undesirable mismatch between communication paths.

For a first trial of determining the best settings to apply to the impedance adjustment circuit 310 to correct the mismatch, the controller 140-3 initially sets the capacitor CTP in adjustment circuit 310 to 5 femto-farads and the capacitor CTN in adjustment circuit 310 to 5 femto-farads. The controller 140-3 then applies the input signal 104-1T to the input of the transmitter circuitry 130-1 as shown FIG. 10 for phase 2. This results in the generation of signals between time T6 and T7 in which the controller 140-3 measures the TPD_ON time to be 24.7 nanoseconds. The controller 140-3 stores this value of TPD_ON = 24.7 nanoseconds for the tested capacitor settings.

For a second trial of determining the best settings to apply to the impedance adjustment circuit 310, the controller 140-3 sets the capacitor CTP to 5 femto-farads and the capacitor CTN to 75 femto-farads. The controller 140-3 then applies the input signal 104-1T to the input of the transmitter circuitry 130-1 as shown in FIG. 10 for phase 2. This results in the generation of signals between time T6 and T7 in which the controller 140-3 measures the TPD_ON time to be 30.1 nanoseconds. The controller 140-3 stores this value of TPD _ON = 30-1 nanoseconds for the tested capacitor settings.

For a third trial of determining the best settings to apply to the impedance adjustment circuit 310, the controller 140-3 sets the capacitor CTP to 5 femto-farads and the capacitor CTN to 200 femto-farads. The controller 140-3 then applies the input signal 104-1T to the input of the transmitter circuitry 130-1 as shown in FIG. 10 for phase 2. This results in the generation of signals between time T6 and T7 in which the controller 140-3 measures the TPD_ON time to be 28.7 nanoseconds. The controller 140-3 stores this value of TPD_ON = 28.7 nanoseconds for the tested capacitor settings.

For a fourth trial of determining the best settings to apply to the impedance adjustment circuit 310, the controller 140-3 sets the capacitor CTP to 5 femto-farads and the capacitor CTN to 500 femto-farads. The controller 140-3 then applies the input signal 104-1T to the input of the transmitter circuitry 130-1 as shown in FIG. 10 for phase 2. This results in the generation of signals between time T6 and T7 in which the controller 140-3 measures the TPD_ON time to be 13.1 nanoseconds. The controller 140-3 stores this value of TPD_ON = 13.1 nanoseconds for the tested capacitor settings.

Because the measured TPD_ON is longest for the second trial, the controller 140-3 determines the best settings to be CTP = 5 femto-farads and CTN = 75 femto-farads and to reduce the mismatch and stores these settings for use in the non-test mode. These best settings support better channel matching of the communication path 128-1 and the communication path 128-2 and, thus, providing better immunity to transient ground differences between ground reference GND1 and ground reference GND2. For test conditions in which the magnitude of the TPD_ON is less than 30.1 nanoseconds correspond to conditions in which there is greater mismatch between the communication path 128-1 and the communication path 128-2.

The controller 140-3 stores the best settings (CTP = 5 femto-farads and CTN = 75 femto-farads for reducing the capacitive communication path mismatch) in adjustment settings 465. During the non-test mode, the controller 140-3 applies the stored adjustment information 465 and corresponding best settings to the impedance adjustment circuit 310. As previously discussed, the adjustment information 465 may include best calibration settings for capacitance, resistance, etc. associated with the impedance adjustment circuit 310.

FIG. 11 is an example diagram illustrating implementation of threshold adjustments to increase sensitivity of a receiver as described herein.

As shown, FIG. 11 illustrates waveforms associated with operating the transmitter circuit 130-1 and the receiver circuit 120-2 in a test mode including 2 phases.

In the first phase, between time T11 and time T16, the comparator 931 offset error (Voffset) of the demodulator 330 (in the receiver circuitry 120-2) is canceled out by the controller 140-3 adjusting the amount of trim current 911 (a.k.a., Itrim_p) and 912 (Itrim_n) being pulled or pushed to the comparator 931. During this offset cancelation phase one, no signal is being transmitted from the transmitter side (i.e., the input signal 104-1T is set to 0), which allows the detection of the comparator trip point by the controller 140-3 via observing only the output signal 104-2T of the comparator 931.

Between time T11 and time T12, while the magnitude of the differential signal VON - VDCN is voltage level L3, the controller 140-3 increases the magnitude of the trim current 911 supplied to the comparator 931 while the trim current 912 is constant. In such an instance, this causes the threshold level 950 to reduce a magnitude between time T11 and time T12. During this time, the controller 140-3 monitors a magnitude of the output signal 104-2T for a change from a logic 1 to a logic 0. In this example, the controller 140-3 does not detect a respective transition of the output signal 104-2 T from logical 1 to logic zero in this window.

Between time T12 and time T15, while the magnitude of the differential signal VON - VDCN is voltage L3, the controller 140-3 increases the magnitude of the trim current 912 supplied to the comparator 931 while the current 911 is constant. In such an instance, this causes the threshold level 950 to increase a magnitude between time T12 and time T15. During this time, the controller 140-3 monitors a magnitude of the output signal 104-2T for a change from a logic 1 to a logic 0. In this example, the controller 140-3 detects a respective transition of the output signal 104-2 from logical 1 to logic 0 at time T13. The controller 140-3 stores the settings of trim current 911 and 912 associated with just before time T13.

In this example, the trip point is determined as a value of trim current 911 and value of the trim current 912 just prior to time T13. The controller 140-3 stores these trip settings for the second phase.

As mentioned, this procedure is generally a scaled-down version of a CMT event. Hence, the first phase is implemented to increase the sensitivity of the comparator 931 by increasing a magnitude of the threshold level 950.

In the second phase, the controller 140-3 applies the stored settings of trim current 911 and trim current 912 (associated with timeT13 and level L3) to the comparator 931 to set the threshold level 950 to voltage level L3. The controller 140-3 also operates the transmitter circuit 130-1 in the test mode by setting the dft_mode signal (i.e., signal 405 of FIG. 4) to a logic high level; the input signal 104-1T is also modulated with the carrier, produced by the oscillator 420, and produces two high-frequency signals such as signal TXP_0 inputted to capacitor CB1 and signal TXN_0 inputted to capacitor CB2. The signal TXP_0 is substantially the same as signal TXN_0. This common-mode signal (of TXP_0 and TXN_0) is transmitted over the channel RLC network (the mismatched capacitive communication paths 128-1 and 128-2).

As shown and as previously discussed in FIG. 5, the communication path 128-1 includes the parasitic capacitance CPAR_P and CPAR N. The magnitude of the parasitic capacitances CPAR_P and CPAR N may be any suitable values.

The difference between CPAR_P and CPAR N (i.e., mismatch) results in a small differential voltage signal between the RXP_I (INP) and RXN_I (INN) terminals of the receiver circuit 120-2. Since this common-mode perturbation is generated by the transmitter oscillator 420, it will possess the carrier frequency, hence it will be amplified by the BPF 320 on the receiver circuit 120-2 (bpfp_o-bpfn_o) or (OUTP-OUTN). This amplified differential signal (VON-VDCN) is integrated by the envelop detector 110-1 until the integrated voltage is detected (differential signal VON-VDCN crosses or is greater than the threshold level 950) by the demodulator comparator 931 (at time T17), recall that the comparator 931 had its sensitivity increased in phase 1 via the stored trim current settings associated with time T13. Since the gain of the BPF 320 is limited, the time propagation delay (TPD_ON) between T16 and T17 is a measure of how high the differential input signal is at the receiver side (rxp_i-rxn_i). As discussed above, the amount of differential signal due to the common-mode disturbance in this particular scenario is a measure of how much RLC mismatch is present between the communication path 128-1 and communication path 128-2. Therefore, determining TPD_ON under these test conditions is equivalent to measuring the RLC channel network mismatch.

During the second phase, via trial and error, the controller 140-3 repeatedly sets the capacitor CTP in capacitor CTN to different values to determine which of multiple different possible settings of CTP and CTN provide the longest delay time TPD_ON. As previously discussed, the longer this delay time, the lower the impedance mismatch between the capacitive communication path 128-1 and the capacitive communication path 128-2, providing best transient and data error immunity.

As an example, assume that the capacitance of the parasitic capacitor CPAR_P is 45 femto-Farads and the parasitic capacitance of the capacitor CPAR_N is 30 femto-Farads. This results in an undesirable mismatch between communication paths.

For a first trial of determining the best settings to apply to the impedance adjustment circuit 310 to correct the mismatch, the controller 140-3 initially sets the capacitor CTP to 5 femto-farads and the capacitor CTN to 65 femto-farads. The controller 140-3 then applies the input signal 104-1T to the input of the transmitter circuitry 130-1 as shown FIG. 11 for phase 2. This results in the generation of signals between time T16 and T17 in which the controller 140-3 measures the TPD_ON time to be 20.7 nanoseconds. The controller 140-3 stores this value of TPD_ON = 20.7 nanoseconds for the tested capacitor settings.

For a second trial of determining the best settings to apply to the impedance adjustment circuit 310, the controller 140-3 sets the capacitor CTP to 85 femto-farads and the capacitor CTN to 55 femto-farads. The controller 140-3 then applies the input signal 104-1T to the input of the transmitter circuitry 130-1 as shown in FIG. 11 for phase 2. This results in the generation of signals between time T16 and T17 in which the controller 140-3 measures the TPD _ON time to be 32.1 nanoseconds. The controller 140-3 stores this value of TPD _ON = 32.1 nanoseconds for the tested capacitor settings.

For a third trial of determining the best settings to apply to the impedance adjustment circuit 310, the controller 140-3 sets the capacitor CTP to 185 femto-farads and the capacitor CTN to 5 femto-farads. The controller 140-3 then applies the input signal 104-1T to the input of the transmitter circuitry 130-1 as shown in FIG. 11 for phase 2. This results in the generation of signals between time T16 and T17 in which the controller 140-3 measures the TPD_ON time to be 38.7 nanoseconds. The controller 140-3 stores this value of TPD_ON = 38.7 nanoseconds for the tested capacitor settings.

For a fourth trial of determining the best settings to apply to the impedance adjustment circuit 310, the controller 140-3 sets the capacitor CTP to 500 femto-farads and the capacitor CTN to 5 femto-farads. The controller 140-3 then applies the input signal 104-1T to the input of the transmitter circuitry 130-1 as shown in FIG. 11 for phase 2. This results in the generation of signals between time T16 and T17 in which the controller 140-3 measures the TPD_ON time to be 10.1 nanoseconds. The controller 140-3 stores this value of TPD_ON = 10.1 nanoseconds for the tested capacitor settings.

Because the TPD_ON is longest for the third trial, the controller 140-3 determines the best settings to be CTP = 185 femto-farads and CTN = 5 femto-farads and to reduce the mismatch and stores these settings in adjustment settings 465 for use in the non-test mode. These best settings support better channel matching of the communication path 128-1 and the communication path 128-2 and, thus, better immunity to transient ground differences between ground reference GND1 and ground reference GND2. For test conditions in which the magnitude of the TPD_ON is less than 38.1 nanoseconds correspond to conditions in which there is greater mismatch between the communication path 128-1 and the communication path 128-2.

The controller 140-3 stores the best settings (CTP = 185 femto-farads and CTN = 5 femto-farads for reducing the capacitive communication path mismatch) in adjustment settings 465. During the non-test mode, the controller 140-3 applies the stored adjustment information 465 and corresponding best settings to the impedance adjustment circuit 310. As previously discussed, the adjustment information 465 may include best calibration settings for capacitance, resistance, etc. associated with the impedance adjustment circuit 310.

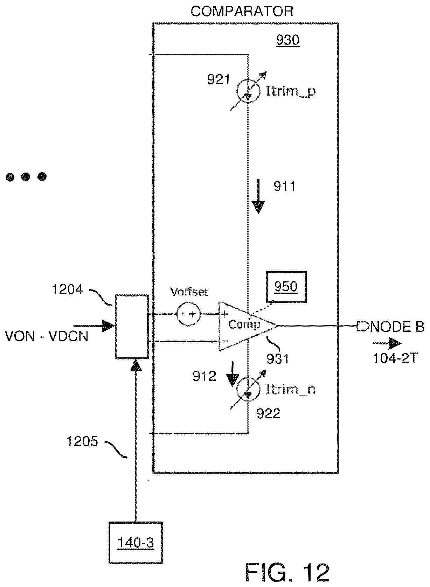

FIG. 12 is an example diagram illustrating implementation of gain adjustments to support calibration as described herein.

As an alternative to adjusting the threshold level 950 or increasing sensitivity of the comparator 931 to determine adjustment settings 465, techniques here include replacing the first phase of the trimming method with increasing the gain/integration time of envelop detector 110-2 by adjusting the bias current and IB4 and the values of each instance of R and C in FIG. 8. So instead of increase the sensitivity of the comparator 931 via adjusting the respective threshold level 950, by eliminating the comparator offset, the system would be left with the "standard offset" (i.e., the level L1 in FIG. 10), which normally would not be crossed for the small signal that is generated in test mode configuration. However, since the envelope detector gain/integration time is increased, this threshold level can be crossed in test mode and the propagation delay is again a measure of channel mismatch degree. The rest of the trimming process (phase 2) would be the same as previously discussed. The impedance adjustment circuit 310 (such as Zin block) can be configured with trimmable capacitors CTP and CTN (see FIG. 4 1) which can be added or removed until the highest TPD_ON is determined for a corresponding setting of the impedance adjustment circuit 310.

The gain associated with differential signal (VON-VDCN) can be set in any suitable matter. For example, the threshold level 950 may be set to a value implemented during a non-test mode. As previously discussed, in the test mode, the signal (VON-VDCN) may not exceed the threshold level 950 in the test mode. Instead of adjusting the threshold level, the controller 140-3 can be configured to increase the gain (such as via generating control signal 1205 to increase the gain) associated with the amplifier 1204 (abstract representation of the gain associated with the receiver circuit) in the test mode. This ensures that the amplified differential signal (VON-VDCN) monitored by the comparator 931 crosses the threshold 950. The controller 140-3 repeats the phase 2 testing as previously discussed to determine and store a best set of adjustments (in adjustment settings 465) to apply to the impedance adjustment circuit 310 to provide better RLC matching of the capacitive communication path 128-1 to capacitive communication path 128-2.

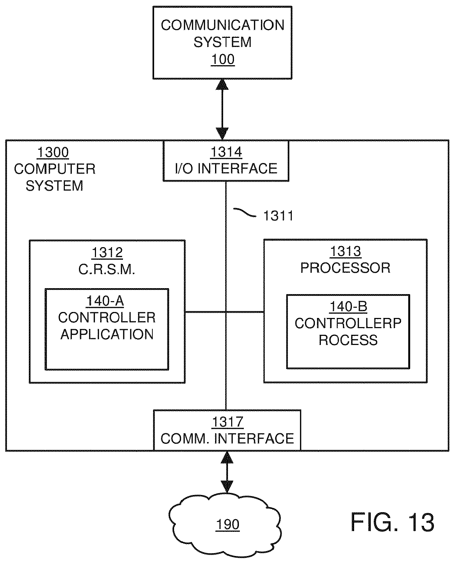

FIG. 13 is an example block diagram of a computer device for implementing any of the operations as discussed herein.

As shown, computer system 1300 (such as implemented by any of one or more resources such as controller, etc.) of the present example includes an interconnect 1311 that couples computer readable storage media 1312 such as a non-transitory type of media (or hardware storage media) in which digital information can be stored and retrieved, a processor 1313 (e.g., computer processor hardware such as one or more processor devices), I/O interface 1314, and a communications interface 1317.

Computer system 1300 such as associated with the controller controls communication system 100 to execute any operations associated with fabrication of the communication system 100 as discussed herein.

I/O interface 1314 provides connectivity to any suitable circuitry or component such as communication system 100, etc.

Computer readable storage medium 1312 can be any hardware storage resource or device such as memory, optical storage, hard drive, floppy disk, etc. The computer readable storage medium 1312 can be configured to store instructions and/or data used by the controller application 140-A to perform any of the operations as described herein.

Further in this example, communications interface 1317 enables the computer system 1300 and processor 1313 to communicate over a resource such as network 190 to retrieve information from remote sources and communicate with other computers.

As shown, computer readable storage media 1312 is encoded with controller application 140-A (e.g., software, firmware, etc.) executed by processor 1313. Controller application 140-A can be configured to include instructions to implement any of the operations as discussed herein.

During operation, processor 1313 accesses computer readable storage media 1312 via the use of interconnect 1311 in order to launch, run, execute, interpret or otherwise perform the instructions in controller application 140-A stored on computer readable storage medium 1312.

Execution of the controller application 140-A produces processing functionality such as controller process 140-B in processor 1313. In other words, the controller process 140-2 associated with processor 1313 represents one or more aspects of executing controller application 14-A within or upon the processor 1313 in the computer system 1300.

Note that computer system 1300 can be a micro-controller device, logic, hardware processor, hybrid analog/digital circuitry, etc., configured to control a power supply and perform any of the operations as described herein.

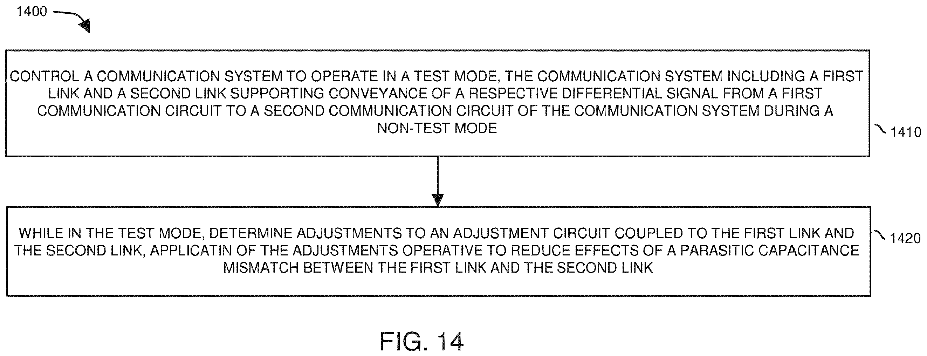

Functionality supported by the different resources will now be discussed via flowchart 1400 in FIG. 14. Note that the steps in the flowcharts below can be executed in any suitable order.

FIG. 14 is an example diagram illustrating a method of controlling a power converter.

In processing operation 1410, the controller 140 control the communication system 100 to operate in a test mode. As previously discussed, the communication system 100 includes a first link 127-1 and a second link 127-2 supporting conveyance of a respective differential signal from a first communication circuit 171-1 to a second communication circuit 171-2 of the communication system 100 during a non-test mode.

In processing operation 1420, while in the test mode, the controller 140 applies adjustments to an adjustment circuit coupled to the first link 127-1 and the second link 127-2 to determine adjustment settings 465. Later application of the adjustment settings 465 reduces effects of a parasitic capacitance mismatch between the first link 127 and the second link 127-2. In other words, the application of the adjustment settings 465 results in a better matching of the communication path 128-1 and the communication path 128-2.

Note again that techniques herein are well suited for use in communication system supporting conveyance of data. However, it should be noted that the concepts in this disclosure are not limited to use in such applications and that the techniques discussed herein are well suited for other applications as well.

Based on the description set forth herein, numerous specific details have been set forth to provide a thorough understanding of claimed subject matter. However, it will be understood by those skilled in the art that claimed subject matter may be practiced without these specific details. In other instances, methods, apparatuses, systems, etc., that would be known by one of ordinary skill have not been described in detail so as not to obscure claimed subject matter. Some portions of the detailed description have been presented in terms of algorithms or symbolic representations of operations on data bits or binary digital signals stored within a computing system memory, such as a computer memory. These algorithmic descriptions or representations are examples of techniques used by those of ordinary skill in the data processing arts to convey the substance of their work to others skilled in the art. An algorithm as described herein, and generally, is considered to be a self-consistent sequence of operations or similar processing leading to a desired result. In this context, operations or processing involve physical manipulation of physical quantities. Typically, although not necessarily, such quantities may take the form of electrical or magnetic signals capable of being stored, transferred, combined, compared or otherwise manipulated. It has been convenient at times, principally for reasons of common usage, to refer to such signals as bits, data, values, elements, symbols, characters, terms, numbers, numerals or the like. It should be understood, however, that all of these and similar terms are to be associated with appropriate physical quantities and are merely convenient labels. Unless specifically stated otherwise, as apparent from the following discussion, it is appreciated that throughout this specification discussions utilizing terms such as "processing," "computing," "calculating," "determining" or the like refer to actions or processes of a computing platform, such as a computer or a similar electronic computing device, that manipulates or transforms data represented as physical electronic or magnetic quantities within memories, registers, or other information storage devices, transmission devices, or display devices of the computing platform.

Some of the aspects explained above are briefly summarized in the following with reference to examples.

Example 1. An apparatus comprising: a controller operative to: control a communication system to operate in a test mode, the communication system including a first link and a second link supporting conveyance of a respective differential signal from a first communication circuit to a second communication circuit of the communication system during a non-test mode; and while in the test mode, determine adjustment settings in which to apply to an impedance adjustment circuit coupled to the first link and the second link, application of the adjustment settings operative to reduce effects of a parasitic capacitance mismatch between the first link and the second link.

Example 2. The apparatus as in example 1, wherein application of the adjustment settings includes adjustment of a capacitance of a capacitor in the impedance adjustment circuit, the capacitor coupled to the first link.

Example 3. The apparatus as in example 1, wherein application of the adjustment settings includes adjustment of a resistance a resistor in the impedance adjustment circuit, the resistor coupled to the first link.

Example 4. The apparatus as in example 1, wherein the second communication circuit is operative to generate an output signal based on a common signal inputted to both the first link and the second link during the test mode; and wherein the controller is operative to determine the adjustment settings based on the output signal during the test mode.

Example 5. The apparatus as in example 1, wherein the first link is disposed in a first capacitive channel between the first communication circuit and the second communication circuit; and wherein the second link is disposed in a second capacitive channel between the first communication circuit and the second communication circuit, the combination of the first capacitive channel and the second capacitive channel supporting the conveyance of the respective differential signal during the non-test mode.

Example 6. The apparatus as in example 5, wherein the adjustment settings include adjustment of a capacitance of a capacitor in the impedance adjustment circuit, the capacitor coupled to the first capacitive channel.

Example 7. The apparatus as in example 1, wherein the first link is a first wire bond connecting a first node of the first communication circuit to a first node of the second communication circuit; and wherein the second link is a second wire bond connecting a second node of the first communication circuit to a second node of the second communication circuit.

Example 8. The apparatus as in example 1, wherein the controller is further operative to: during the test mode, via the first communication circuit, input a common signal for conveyance through each of the first link and the second link.

Example 9.The apparatus as in example 8, wherein a magnitude of the common signal varies over time.

Example 10. The apparatus as in example 9, wherein the controller is further operative to: during the test mode, adjust a detector circuit disposed in the second communication circuit, the detector circuit operable to receive a communication signal derived from applying the common signal to each of the first link and the second link, the detector circuit further operative to compare the received communication signal to a threshold value during the test mode to determine a degree of the parasitic capacitance mismatch.

Example 11. The apparatus as in example 1, wherein the controller is further operative to: during the test mode, via the first communication circuit, input a common signal to: i) a first capacitive channel including the first link, and ii) the second capacitive channel including the second link; and control operation of the detector circuit to: i) amplify a differential communication signal received over the first capacitive channel and the second capacitive channel, ii) compare the amplified differential communication signal to a threshold value to produce an output signal, and iii) select the adjustment settings based on the output signal.

Example 12. The apparatus as in example 11, wherein control of the detector circuit includes: adjustment of a gain circuit amplifying the received communication signal into the amplified differential communication signal.

Example 13. The apparatus as in example 1, wherein the communication system includes a first capacitor disposed in series between the first wireless link and the impedance adjustment circuit; and wherein the communication system includes a second capacitor disposed in series between the second wireless link and the impedance adjustment circuit.

Example 14. The apparatus as in example 1, wherein application of the adjustment settings during the non-test mode reduces a difference in signal propagation delay over a first capacitive channel including the first link and a second capacitive channel including the second link.

Example 15. A method comprising: controlling a communication system to operate in a test mode, the communication system including a first link and a second link supporting conveyance of a respective differential signal from a first communication circuit to a second communication circuit of the communication system during a non-test mode; and while in the test mode, determining adjustment settings in which to apply to an impedance adjustment circuit coupled to the first link and the second link, application of the adjustment settings operative to reduce effects of a parasitic capacitance mismatch between the first link and the second link.

Example 17. The method as in example 16, wherein application of the adjustment settings includes adjusting a capacitance of a capacitor in the impedance adjustment circuit, the capacitor coupled to the first link.

Example 18. The method as in example 16, wherein application of the adjustment settings includes adjusting a resistance a resistor in the impedance adjustment circuit, the resistor coupled to the first link.

Example 19. The method as in example 16, wherein the second communication circuit is operative to generate an output signal based on a common signal inputted to both the first link and the second link during the test mode; and wherein the controller is operative to determine the adjustment settings based on the output signal during the test mode.

Example 20. The method as in example 16, wherein the first link is disposed in a first capacitive channel between the first communication circuit and the second communication circuit; and wherein the second link is disposed in a second capacitive channel between the first communication circuit and the second communication circuit, the combination of the first capacitive channel and the second capacitive channel supporting the conveyance of the respective differential signal during the non-test mode.

Example 21. The apparatus as in example 1, wherein the first link is disposed in a first inductive channel between the first communication circuit and the second communication circuit; and wherein the second link is disposed in a second inductive channel between the first communication circuit and the second communication circuit, the combination of the first inductive channel and the second inductive channel supporting the conveyance of the respective differential signal during the non-test mode.

## Claims

1. An apparatus comprising:
a controller configured to:
control a communication system to operate in a test mode, the communication system (100) including a first link (127-1) and a second link (127-2) supporting conveyance of a respective differential signal from a first communication circuit (171-1) to a second communication circuit (171-2) of the communication system (100) during a non-test mode; and
while in the test mode, determine adjustment settings to be applied to an impedance adjustment circuit (310) coupled to the first link (127-1) and the second link (127-1), application of the adjustment settings operative to reduce effects of a parasitic capacitance mismatch between the first link (127-1) and the second link (127-2).

2. The apparatus as in claim 1, wherein application of the adjustment settings includes adjustment of a capacitance of a capacitor (CTP) in the impedance adjustment circuit, the capacitor coupled to the first link.

3. The apparatus as in claim 1, wherein application of the adjustment settings includes adjustment of a resistance a resistor (Rpd) in the impedance adjustment circuit (310), the resistor (Rpd) coupled to the first link (127-1).

4. The apparatus as in any one of claims 1 to 3,
wherein the second communication circuit (171-2) is configured to generate an output signal (104-2) based on a common signal inputted to both the first link (127-1) and the second link (127-2) during the test mode; and
wherein the controller (140-1) is operative to determine the adjustment settings based on the output signal during the test mode.

5. The apparatus as in any one of claims 1 to 4,
wherein the first link (127-1) is disposed in a first capacitive channel between the first communication circuit (171-1) and the second communication circuit (171-2); and
wherein the second link (171-2) is disposed in a second capacitive channel between the first communication circuit (171-1) and the second communication circuit (171-2),
wherein the combination of the first capacitive channel and the second capacitive channel is configured to supports the conveyance of the respective differential signal during the non-test mode.

6. The apparatus as in claim 5,
wherein the adjustment settings include adjustment of a capacitance of a capacitor (CTP) in the impedance adjustment circuit (310),
wherein the capacitor is coupled to the first capacitive channel.

7. The apparatus as in any one of claims 1 to 6,
wherein the first link (127-1) is a first wire bond connecting a first node (147-1) of the first communication circuit (171-1) to a first node (147-2) of the second communication circuit (171-2); and
wherein the second link (127-2) is a second wire bond connecting a second node (148-1) of the first communication circuit (171-1) to a second node (148-2) of the second communication circuit (171-2).

8. The apparatus as in any one of claims 1 to 7, wherein the controller (140-1) is further configured to:
during the test mode, via the first communication circuit (171-1), input a common signal for conveyance through each of the first link (127-1) and the second link (127-2).

9. The apparatus as in claim 8, wherein a magnitude of the common signal varies over time.

10. The apparatus as in claim 9, wherein the controller (140-1) is further configured to:
during the test mode, adjust a detector circuit disposed in the second communication circuit (171-2),
wherein the detector circuit is configured to receive a communication signal derived from applying the common signal to each of the first link (127-1) and the second link (127-2), and
wherein the detector circuit is further configured to compare the received communication signal to a threshold value during the test mode to determine a degree of the parasitic capacitance mismatch.

11. The apparatus as in claim 10, wherein the controller (140-1) is further configured to:
during the test mode, via the first communication circuit (171-1), input a common signal to: i) a first capacitive channel including the first link (127-1), and ii) the second capacitive channel including the second link (127-2); and
control operation of the detector circuit to: i) amplify a differential communication signal received over the first capacitive channel and the second capacitive channel, ii) compare the amplified differential communication signal to a threshold value to produce an output signal, and iii) select the adjustment settings based on the output signal.

12. The apparatus as in claim 11, wherein control of the detector circuit includes: adjustment of a gain circuit amplifying the received communication signal into the amplified differential communication signal.

13. The apparatus as in any one of claims 1 to 12,
wherein the communication system includes a first capacitor (CB3) disposed in series between the first link (127-1) and the impedance adjustment circuit (310); and
wherein the communication system includes a second capacitor (CB4) disposed in series between the second link (127-2) and the impedance adjustment circuit (310).

14. The apparatus as in any one of claims 1 to 13, wherein application of the adjustment settings during the non-test mode reduces a difference in signal propagation delay over a first capacitive channel including the first link (127-1) and a second capacitive channel including the second link (127-2).

15. A method comprising:
controlling a communication system to operate in a test mode, the communication system including a first link (127-1) and a second link (127-2) supporting conveyance of a respective differential signal from a first communication circuit (171-1) to a second communication circuit (171-2) of the communication system (100) during a non-test mode; and
while in the test mode, determining adjustment settings to be applied to an impedance adjustment circuit (310) coupled to the first link (127-1) and the second link (127-2), application of the adjustment settings operative to reduce effects of a parasitic capacitance mismatch between the first link and the second link.
